# EUROPÄISCHE PATENTANMELDUNG

(11) **EP 3 249 416 A1**
(43) Veröffentlichungstag der Anmeldung: **29.11.2017**
(21) Anmeldenummer: 16171134.6
(22) Anmeldetag: 24.05.2016
(51) Int. Cl.: G01R 31/08, G01R 31/11

(54) **KABELSCHADENDIAGNOSTIK**

(71) Anmelder: Airbus Defence and Space GmbH, 82024 Taufkirchen (DE)
(72) Erfinder: HAHN, Sebastian, 81545 München (DE); ELEFSINIOTIS, Alexandros, 81375 München (DE)
(74) Vertreter: Isarpatent

(57) **Zusammenfassung**

Die Erfindung betrifft ein Verfahren zur Schadstellenermittlung an elektrischen Signaltransportmitteln (20), mit wenigstens einem Signaltransportmittel (20), in dessen Nutzbetrieb ein Übertragungssignal mit einem elektrischen Nutzsignal zwischen Enden einer Übertragungstrecke des Signaltransportmittels transportierbar ist oder transportiert wird. Um ein Verfahren zur Schadstellenermittlung an elektrischen Signaltransportmitteln (20) zur Verfügung zu haben, welches mit geringem Aufwand eine zuverlässige Diagnostik von Schadstellen (40) gestattet, wird vorgeschlagen, dass die Übertragungsstrecke (25) des Signaltransportmittels (20) während der Schadstellenermittlung im Nutzbetrieb betrieben wird, und im Nutzbetrieb das Übertragungssignal an wenigstens einem Ende der Übertragungsstrecke (25) aufgezeichnet und mittels wenigstens einer Signalverarbeitungseinrichtung (30) an dem aufgezeichneten Übertragungssignal eine Unterscheidung in einen Nutzsignalanteil und wenigstens einen weiteren Anteil, insbesondere einen Reflektionsanteil, vorgenommen wird.

## Beschreibung

Die Erfindung betrifft ein Verfahren zur Schadstellenermittlung an elektrischen Signaltransportmitteln, mit wenigstens einem Signaltransportmittel, in dessen Nutzbetrieb ein Übertragungssignal mit einem elektrischen Nutzsignal zwischen Enden einer Übertragungstrecke des Signaltransportmittels transportierbar ist oder transportiert wird. Außerdem betrifft die Erfindung ein Signalübermittlungssystem zur Durchführung eines solchen Verfahrens.

Bei der Übertragung elektrischer Signale können die als Signalübertragungsmittel eingesetzten Kabel als Kabelbäume zusammengefasst sein, wobei die Übertragungsstrecken an Kabeln dieser Kabelbäume, die in den vorliegenden Ausführungen ausschließlich solche zur Datenübertragung sind, aufgrund von Umgebung oder Belastungen grundsätzlich beschädigt werden können. Hierbei kann grundsätzlich zwischen zwei Typen von Schäden unterschieden werden, nämlich zwischen sogenannten "Hard Faults", bei deren Auftreten eine Datenübertragung nicht mehr möglich ist, und sogenannten "Soft Faults", bei deren Auftreten das jeweilige System funktional nicht beeinträchtigt und somit eine Datenübertragung weiterhin möglich ist. Dabei können diese Soft Faults ohne Intervention sehr wohl zu Hard Faults werden. Durch eine geeignete Diagnostik können jedoch auch Soft Faults grundsätzlich rechtzeitig erkannt werden. Um den Reparaturaufwand niedrig zu halten, ist es grundsätzlich erstrebenswert, die Position des Schadens möglichst genau zu identifizieren, um z.B. den Aufwand zum Entfernen von Verkleidung etc. niedrig zu halten.

Jegliche Art von Schäden an Übertragungsstrecken (Kabelbäumen, Kabel und Steckverbindungen sollen hier verallgemeinert als Einheit betrachtet werden) erzeugt eine Änderung der charakteristischen Impedanz an der Stelle des Schadens. Änderungen der Impedanz innerhalb einer Übertragungsstrecke erzeugen grundsätzlich Reflektionen, d.h. ein bestimmter Teil des einfallenden Signals wird zum Sender zurück reflektiert. Bei Soft Faults sind die Impedanzänderungen und damit die Reflektionen meist eher klein, eine maximale Amplitude soll aus Gründen der Verallgemeinerung jedoch nicht spezifiziert werden.

Besteht ein Kurzschluss oder eine komplett aufgetrennte Leitung, wird das komplette Signal reflektiert. Eine Datenübertragung und damit die passive Diagnostik ist damit jedoch nicht mehr möglich. Grundsätzlich werden höherfrequente/breitbandigere Signale an Schadstellen stärker reflektiert als niederfrequente; für Gleichstrom treten keine Reflektionen mehr auf.

Neuere Datenübertragungstechnologien, im speziellen Ethernet, weisen eine immer höhere Datenrate auf. Dadurch steigt auch die Bandbreite bzw. die Frequenz der Datensignale, wodurch genannte Reflektionen sichtbarer werden als mit traditionelleren, eher niederfrequenten Datenlinks.

Zur Ermittlung von Fehlerstellen kennt man bereits verschiedene Methoden, wie etwa die Zeitdömänenreflektometrie (Time Domain Reflectometry, TDR), bei welcher eine Pulsflanke erzeugt wird, deren Steilheit mit der Bandbreite korreliert und die auftretenden Reflektionen erfasst werden. Deren zeitliche Verzögerung lässt einen Rückschluss auf die Position des Fehlers zu. Die zeitliche Verzögerung kann mit Kenntnis der Signalgeschwindigkeit auf eine Längenangabe umgerechnet werden.

Weiter bekannt ist die aus der Akustik geläufige Methode der Zeitumkehr ("Time Reversal"). Bei dieser senden und empfangen Sender/Empfänger an den Enden der Übertragungsstrecke jeweils einen hochfrequenten Puls, das jeweils empfangene Signal wird aufgezeichnet und zeitlich umgekehrt wiederum von beiden Sendern gleichzeitig ausgesandt, wobei dieser Vorgang mehrfach wiederholt wird. Nach einigen Iterationen konvergiert das empfangene Signal derart, dass die Schadstelle anhand des Signals sichtbar wird.

Schließlich kennt man auch die Resonanzlinienanalyse (Line Resonance Analysis, "LIRA"), bei der wiederum Schadstellen im Kabel Reflektionen verursachen. Die Reflektionen können am Sender entweder konstruktiv oder destruktiv wirken, d.h. durch diese Überlagerung "sieht" der Sender eine höhere oder niedrigere Eingangsimpedanz der Übertragungsstrecke, als er sie schadensfrei sähe. Die Impedanz oszilliert dann grundsätzlich über der Frequenz, der Abstand der Minima und Maxima korreliert zum Abstand der Schadstelle zum Sender.

Den vorgenannten Methoden ist gemein, dass sie ein eigenes Testsignal zur Durchführung der Diagnostik benötigen. Weiterhin wird üblicherweise zusätzliches, teures Testequipment zur Durchführung benötigt.

Es besteht daher die Aufgabe, ein Verfahren zur Schadstellenermittlung an elektrischen Signaltransportmitteln zur Verfügung zu stellen, welches mit geringem Aufwand eine zuverlässige Diagnostik von Schadstellten gestattet.

Diese Aufgabe wird gelöst durch ein Verfahren der eingangs genannten Art mit den Merkmalen des Hauptanspruchs. Insbesondere zeichnet sich das Verfahren demnach dadurch aus, dass erfindungsgemäß die Übertragungsstrecke des Signaltransportmittel während der Schadstellenermittlung im Nutzbetrieb betrieben wird und im Nutzbetrieb das Übertragungssignal an wenigstens einem Ende der Übertragungsstrecke aufgezeichnet und mittels wenigstens einer Signalverarbeitungseinrichtung an dem aufgezeichneten Übertragungssignal eine Unterscheidung in einen Nutzsignalanteil und wenigstens einen weiteren Anteil, insbesondere einen Reflektionsanteil, vorgenommen wird. Weitere vorteilhafte Merkmale beinhalten die Unteransprüche.

Erfindungsgemäß wird hierdurch als Verfahren zur Schadstellenermittlung eine Art passive Kabeldiagnose vorgeschlagen. Vorteilhaft an dem Verfahren ist insbesondere, dass zu dessen Durchführung kein externes Testequipment sowie kein zusätzliches Testsignal mehr notwendig sind. Sämtliche notwendigen Informationen werden bereits im Empfänger des Übertragungssystems zusammen mit dem Nutz-Datensignal aufgezeichnet. Durch geeignete Methoden der Signalverarbeitung (z.B. Echo Cancellation, Korrelation) können Nutzdatensignale und Reflektionen im laufenden Betrieb unterschieden werden, wodurch Diagnostik im laufenden Betrieb und ohne extra Testsignal möglich wird.

Die im Rahmen passiver Kabeldiagnostik im laufenden Datenbetrieb auftretenden, "sichtbaren" Reflektionen des Datensignals können bei einer Variante des erfindungsgemäßen Verfahrens zur Schadstellenermittlung zuverlässig erfasst werden, wenn die Reflektionen des Reflektionsanteils des Übertragungssignals als Änderung einer charakteristischen Impedanz an der jeweils zugeordneten oder zuordenbaren Schadenstelle aufgezeichnet werden.

Einen Rückschluss auf die Position von Schadenstellen erlaubt hierbei auch eine Variante des erfindungsgemäßen Verfahrens, bei welcher die Reflektionen gemeinsam mit den zugeordneten Laufzeiten und/oder Phasenverschiebungen aufgezeichnet und ausgewertet werden.

Eine vorteilhafte Variante des erfindungsgemäßen Verfahrens wertet in zuverlässig durchzuführender Art und Weise anhand des Reflektionsanteils des Übertragungssignals wenigstens einen stochastischer Parameters der Übertragungsstrecke des Signaltransportmittels, insbesondere das Wirkleistungsspektrum als spektrale Leistungsdichte über einen wählbaren Frequenzbereich, aus. Das erfindungsgemäße Verfahren nutzt dabei unter anderem den Umstand, dass bei Verwendung eines perfekten Kabelmediums und einer symmetrischen Vollduplex-Datenverbindung die langfristige spektrale Leistungsdichte auf beiden Seiten der Übertragungsstrecke des Signaltransportmittels wegen der gleichen stochastischen Eigenschaften der Datenübertragung von beiden Seiten und der wechselseitigen Natur des idealen passiven Kanals, also des Signaltransportmittels bzw. Kabels identisch ist. Reflektionen wirken sich dabei sowohl am Sender selbst, aber auch am Empfänger aus, das heißt, die Reflektionen beeinflussen nicht nur das Echo, sondern auch die Übertragung selbst

Soft Faults führen jedoch zu einer Änderung der spektralen Leistungsdichte und anderen stochastischen Eigenschaften zwischen den beiden Seiten der Übertragungsstrecke. Dies wiederum bedeutet, dass aufgrund der Softfehler an der oder Übertragungsstrecken zwar unterschiedliche Reflexionen vorhanden sein werden, die Leitung wird dennoch noch betriebsbereit sein. Diese Reflektionen werden jedoch das reziproke (wechselseitige) Verhalten des Kabels stören, dieser Umstand kann durch Vergleichen der stochastischen Parameter von an den Enden der Übertragungsstrecke angeordneten, die Übertragung durchführenden Transceiver ermittelt werden.

Eine Verbesserung der Diagnostik, insbesondere mit Blick auf ihre Genauigkeit, ist zu erreichen, in dem die Ergebnisse auf beiden Seiten der Übertragungsstrecke miteinander verrechnet werden, weswegen bei einer Weiterbildung des erfindungsgemäßen Verfahrens an beiden Enden der Übertragungsstrecke des Signaltransportmittels Übertragungssignale aufgezeichnet und ausgewertet werden und die Auswertungsergebnisse beider Seiten der Übertragungsstrecke verglichen und/oder verrechnet werden. Üblicherweise werden hierbei die Eigenschaften der Echos (Sender → Sender), sowie der übertragenen Signale (Sender → Empfänger) miteinander verrechnet.

Bei einer weiteren zweckmäßigen Variante des erfindungsgemäßen Verfahrens findet die Aufzeichnung der Übertragungssignale über einen definierbaren Aufzeichnungszeitraum oder permanent statt und/oder es wird durch eine Bedienperson willkürlich ein neuer Startzeitpunkt eines Aufzeichnungszeitraums von Übertragungssignalen festgelegt. Durch Beobachtung / Messung über einen langen Zeitraum (Stunden, Tage, Monate; oder bspw. auch grundsätzlich immer, wenn das System in Betrieb ist) mitteln sich mögliche Messfehler so aus, dass auch kleinere Schäden sichtbar werden. Weiterhin ist eine "Nullung" der Diagnostik möglich (z.B. zur ersten Inbetriebnahme oder nach einer Wartung), wodurch insbesondere frisch auftretende Schäden im zeitlichen Verlauf verfolgbar sind.

In einer Weiterbildung kann hierbei eine zeitliche Entwicklung wenigstens einer Schadenstelle aus einem oder mehreren Aufzeichnungszeiträumen anhand permanenter Aufzeichnung des Übertragungssignals gewonnen oder separat aufgezeichnet werden.

Weiter wird die Aufgabe auch gelöst durch ein erfindungsgemäßes Signalübermittlungssystem mit wenigstens einem Signaltransportmittel, bei welchem System an wenigstens einem Ende der Übertragungsstrecke des Signaltransportmittels zumindest eine Schaltkreisanordnung vorgesehen ist, welche im Nutzbetrieb über die Übertragungsstrecke übertragene Übertragungssignale aufzeichnet und in einen Nutzsignalanteil und zumindest einen weiteren Anteil, insbesondere einen Reflektionsanteil, unterscheidet. Auch durch das wird eine passive Kabeldiagnose etabliert, bei welcher vorteilhaft kein externes Testequipment mehr notwendig ist. erneut werden sämtliche notwendigen Informationen bereits im Empfänger des Übertragungssystems zusammen mit dem Nutz-Datensignal aufgezeichnet. Dabei ist das Nutzsignal hier grundsätzlich breitbandig, es findet also keine direkte Messung/Erfassung einzelner Frequenzen statt. Durch geeignete Methoden der Signalverarbeitung (z.B. Echo Cancellation, Korrelation) können Nutzdatensignale und Reflektionen im laufenden Betrieb unterschieden werden, wodurch Diagnostik im laufenden Betrieb und ohne extra Testsignal möglich wird.

Der Aufbau des erfindungsgemäßen Signalübermittlungssystems wird vereinfacht durch eine zweckmäßige Ausführung, bei der in der zumindest einen Schaltkreisanordnung Signalverarbeitungsmethoden zur Durchführung einer passiven Diagnostik des wenigstens einen Signaltransportmittels implementiert sind.

Eine höhere Diagnosegenauigkeit und Zuverlässigkeit erreicht eine weitere Ausführung des erfindungsgemäßen Signalübermittlungssystems, bei welchem an jedem Ende der Übertragungsstrecke des Signaltransportmittels wenigstens eine Schaltkreisanordnung zur Durchführung einer passiven Diagnostik vorgesehen ist.

Eine hoher Integrationsgrad mit weiteren Komponenten des Signalübermittlungssystems lässt sich mit einer Ausführung erreichen, bei der die zumindest eine Schaltkreisanordnung als PHY-Schaltkreis ausgebildet ist. Dieser kann ein spezieller integrierter Schaltkreis oder eine funktionelle Gruppe eines Schaltkreises sein, die für die Kodierung und Dekodierung von Daten zwischen einem rein digitalen System und einem modulierten analogen sorgt. In einer bevorzugten Weiterbildung kann die zumindest eine Schaltkreisanordnung einen Bestandteil einer Netzwerkschnittstellenkarte bilden.

In einer vorteilhaften Weiterbildung kann das erfindungsgemäße Signalübermittlungssystem Diagnoseergebnisse per geeigneter Schnittstelle zum Datenübertragungssystem bevorzugt in Echtzeit zur Verfügung stellen, weswegen wenigstens eine Schnittstelle zu einem Datenübertragungssystem und/oder wenigstens eine Speichereinrichtung vorgesehen ist. Ist das Datenübertragungssystem mit der passiven Diagnostik in eine entsprechende Umgebung integriert, kann der Zustand des Kabelbaums z.B. grafisch dargestellt werden, wobei eine abschnittsweise Bewertung des Zustands erfolgen kann (z.B. kein Schaden, kleiner Schaden vermutet, Schaden entdeckt, größer werdender Schaden, etc.). Ist der zeitliche Verlauf der Schadstelle bekannt, kann dem Benutzer des Systems evtl. eine Vorhersage über die mögliche verbleibende Betriebsdauer bis zum erwarteten Hard Fault gegeben werden.

Bevorzugt ist das Signaltransportmittel durch zumindest ein Paar von sich zwischen den Enden der Übertragungsstrecke erstreckenden Kabeln, insbesondere von Kupferkabeln, gebildet, die zur Übertragung von Nutzsignalen mit einer Bandbreite von wenigstens 100 Mbit/s, insbesondere im Vollduplexbetrieb, ausgebildet sind. Im Einzelfall kann aber auch ein Verzicht auf die erwähnte, konkrete Datenrate Sinn machen, bei sehr langen Übertragungsstrecken ist das erfindungsgemäße Verfahren bzw. Vorgehen grundsätzlich auch mit niederfrequenten Signalen möglich.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird dabei der Fachmann auch Einzelaspekte als Verbesserungen oder Ergänzungen zu der jeweiligen Grundform der vorliegenden Erfindung hinzufügen.

Die Erfindung wird nachstehend anhand von Ausführungsbeispielen in der Zeichnung näher erläutert. In teilweise schematisierter Darstellung zeigen hierbei
- Fig.1: eine schematische Darstellung einer fehlerfreien Übertragungsstrecke eines Signaltransportmittels mit Auswertung der zugeordneten Wirkleistungsdichte;
- Fig.2: eine Darstellung einer Übertragungsstrecke eines Signaltransportmittels, welche eine soft fault enthält mit Auswertung der zugeordneten Wirkleistungsdichte; und
- Fgi.3: eine Auftragung der Impedanz und deren Änderung über die Übertragungsstrecke.

In allen Figuren sind gleiche bzw. funktionsgleiche Elemente und Vorrichtungen - sofern nichts Anderes angegeben ist - mit denselben Bezugszeichen versehen worden.

In den Fig. und 2 ist ein im Ganzen mit 10 bezeichnetes Signalübermittlungssystem zu erkennen, das mit Signaltransportmitteln 20 versehen ist, die eine Übertragungsstrecke 25 bilden. An den beiden Enden der Übertragungsstrecke 25 des Signaltransportmittels 20 ist jeweils eine Schaltkreisanordnung 32 einer Signalverarbeitungseinrichtung 30 vorgesehen, die im Nutzbetrieb über die Übertragungsstrecke 25 übertragene Übertragungssignale aufzeichnet und in einen Nutzsignalanteil und zumindest einen weiteren Anteil, insbesondere einen Reflektionsanteil, unterscheidet. Das Signalübermittlungssystem 10 wird zur Durchführung eines Verfahrens zur Fehlerermittlung an dem elektrischen Signaltransportmittel 20 eingesetzt, wobei die Übertragungsstrecke 25 des Signaltransportmittel 20 während der Schadstellenermittlung im Nutzbetrieb betrieben wird und im Nutzbetrieb das Übertragungssignal an den Enden der Übertragungsstrecke aufgezeichnet und mittels wenigstens einer Signalverarbeitungseinrichtung 30 an dem aufgezeichneten Übertragungssignal eine Unterscheidung in einen Nutzsignalanteil und wenigstens einen weiteren Anteil, insbesondere einen Reflektionsanteil, vorgenommen wird.

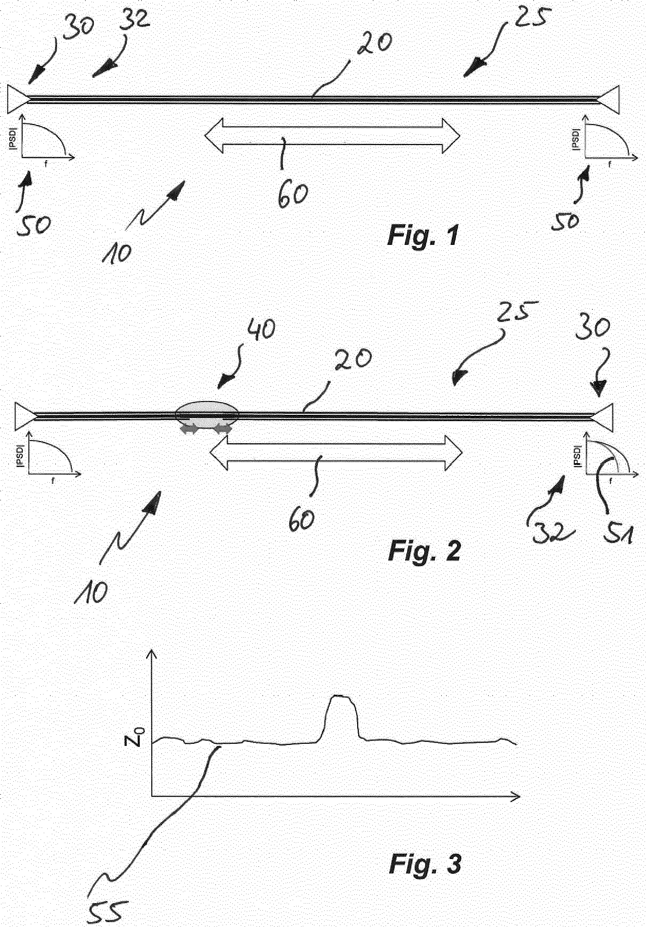

Bei Verwendung eines perfekten Signaltransportmittels 20 als Kabelmedium und einer symmetrischen Vollduplex-Datenverbindung ist die langfristige spektrale Leistungsdichte auf beiden Seiten der Übertragungsstrecke wegen der gleichen stochastischen Eigenschaften der Datenübertragung von beiden Seiten und der wechselseitigen Natur des idealen passiven Kanals (also des Signaltransportmittels 20 bzw. Kabels) identisch, wie es an den Auftragungen 50 des Betrags der identischen Wirkleistungsdichte an den Enden des Kabels in der Fig.1 erkennbar ist.

Soft Faults, wie man einen etwa beispielhaft in der Fig.2 erkennt, führen zu einer Änderung der spektralen Leistungsdichte und anderen stochastischen Eigenschaften zwischen den beiden Seiten der Übertragungsstrecke 25 führen. Bei noch betriebsbereitem Signaltransportmittel werden aufgrund des oder der Soft Faults als Schadstelle 40 unterschiedliche Reflexionen vorhanden sein, welche das reziproke (wechselseitige) Verhalten des Signaltransportmittels 20, dieser Umstand kann durch Vergleichen stochastischer Parameter der beiden Schaltkreisanordnungen 32 der Signalverarbeitungseinrichtung 30 ermittelt werden und führen unter anderem zu einer veränderten Wirkleistungsdichte, wie sie in den betragsmäßigen Auftragungen 50, 51 an den Enden des Kabels in der Fig.2 erkennbar ist.

Anhand der Fig.2 erkennt man also, wie sich beispielsweise die Wirkleistungsdichte ändert. Der Einsatz des erfindungsgemäßen Verfahrens bei neueren Übertragungsstandards, wie beispielsweise dem One Pair Ethernet, bei dem lediglich ein Kabelpaar zur Übertragung von 100 Mbit/s oder sogar 1 Gbit/s bei Vollduplexübertragung, wie sie durch die Doppelpfeile 60 der Fig.1 und 2 angedeutet wird, verwendet wird, große Vorteile haben. Das Sampling und die Echoauslöschung ist bei den verwendeten integrierten Schaltkreisanordnungen 32 bereits implementiert, es kann jedoch eine weitere digitale Signalverarbeitung zur Ermittlung von Softfehlern entlang der Leitung des Signaltransportmittels 20 eingesetzt werden, wodurch die Notwendigkeit zusätzlicher externer Komponenten entfällt.

In der Fig.3 erkennt man schließlich eine Auftragung 55, bei welcher die Änderung der Impedanz innerhalb einer Übertragungsstrecke dargestellt ist, die grundsätzlich Reflektionen erzeugt, was bedeutet, dass ein Anteil des einfallenden Signals zum Sender zurück reflektiert wird. Bei Soft Faults sind die Impedanzänderungen und damit die Reflektionen meist nicht besonders groß, eine maximale Amplitude soll aus Gründen der Verallgemeinerung jedoch nicht spezifiziert werden. Prinzipiell kann dabei jegliche Art von Schäden an Kabeln, wobei Kabel und Steckverbindungen sollen hier verallgemeinert als Einheit betrachtet werden, Änderungen der charakteristischen Impedanz an einer betreffenden Schadensstelle erzeugen, in der Auftragung der Fig.3 sind hierzu als X-Achse die Position der Schadenstelle im Signaltransportmittel 20 und als Y-Achse die Impedanz jeweils in willkürlichen Einheiten aufgetragen.

Mithin wird durch die vorstehenden Ausführungen ein Verfahren zur Schadstellenermittlung an elektrischen Signaltransportmitteln 20 beschrieben, mit wenigstens einem Signaltransportmittel 20, in dessen Nutzbetrieb ein Übertragungssignal mit einem elektrischen Nutzsignal zwischen Enden einer Übertragungstrecke des Signaltransportmittels transportierbar ist oder transportiert wird.

Um ein Verfahren zur Schadstellenermittlung an elektrischen Signaltransportmitteln zur Verfügung zu haben, welches mit geringem Aufwand eine zuverlässige Diagnostik von Schadstellen gestattet, wird die Übertragungsstrecke 25 des Signaltransportmittels 20 während der Schadstellenermittlung im Nutzbetrieb betrieben und im Nutzbetrieb wird das Übertragungssignal an wenigstens einem Ende der Übertragungsstrecke 25 aufgezeichnet und es wird mittels wenigstens einer Signalverarbeitungseinrichtung 30 an dem aufgezeichneten Übertragungssignal eine Unterscheidung in einen Nutzsignalanteil und wenigstens einen weiteren Anteil, insbesondere einen Reflektionsanteil, vorgenommen. Im gleichen Sinne ist ein Signalübermittlungssystem 10 beschrieben, welches diesen Anforderungen genügt.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

### Bezugszeichenliste

- 10: Signalübermittlungssystem
- 20: Signaltransportmittel
- 25: Übertragungsstrecke
- 30: Signalverarbeitungseinrichtung
- 32: Schaltkreisanordnung
- 40: Schadensstelle
- 50: Auftragung Wirkleistungsdichte ohne Schadensstelle
- 51: Auftragung Wirkleistungsdichte bei Vorhandensein Schadensstelle
- 55: Auftragung Impedanz gegen Position Fehlerstelle
- 60: durch Doppelpfeil angedeutete Vollduplexübertragung

## Patentansprüche

1. Verfahren zur Schadstellenermittlung an elektrischen Signaltransportmitteln (20), mit wenigstens einem Signaltransportmittel (20), in dessen Nutzbetrieb ein Übertragungssignal mit einem elektrischen Nutzsignal zwischen Enden einer Übertragungstrecke (25) des Signaltransportmittels (20) transportierbar ist oder transportiert wird, **dadurch gekennzeichnet, dass** die Übertragungsstrecke (25) des Signaltransportmittel (20) während der Schadstellenermittlung im Nutzbetrieb betrieben wird und im Nutzbetrieb das Übertragungssignal an wenigstens einem Ende der Übertragungsstrecke (25) aufgezeichnet und mittels wenigstens einer Signalverarbeitungseinrichtung (20) an dem aufgezeichneten Übertragungssignal eine Unterscheidung in einen Nutzsignalanteil und wenigstens einen Reflektionsanteil vorgenommen wird.

2. Verfahren nach Anspruch 1, **dadurch gekennzeichnet, dass** die Reflektionen des Reflektionsanteils des Übertragungssignals als Änderung einer charakteristischen Impedanz an der jeweils zugeordneten oder zuordenbaren Schadenstelle (40) aufgezeichnet werden.

3. Verfahren nach Anspruch 1 oder 2, **dadurch gekennzeichnet, dass** die Reflektionen gemeinsam mit den zugeordneten Laufzeiten und/oder Phasenverschiebungen aufgezeichnet und ausgewertet werden.

4. Verfahren nach einem der vorhergehenden Ansprüche, **dadurch gekennzeichnet, dass** anhand des Reflektionsanteils des Übertragungssignals wenigstens ein stochastischer Parameter der Übertragungsstrecke (25) des Signaltransportmittels (20), insbesondere das Wirkleistungsspektrum als spektrale Leistungsdichte über einen wählbaren Frequenzbereich, ausgewertet wird.

5. Verfahren nach einem der vorhergehenden Ansprüche, **dadurch gekennzeichnet, dass** an beiden Enden der Übertragungsstrecke (25) des Signaltransportmittels (20) Übertragungssignale aufgezeichnet und ausgewertet werden und die Auswertungsergebnisse beider Seiten der Übertragungsstrecke (25) verglichen und/oder verrechnet werden.

6. Verfahren nach einem der vorhergehenden Ansprüche, **dadurch gekennzeichnet, dass** die Aufzeichnung der Übertragungssignale über einen definierbaren Aufzeichnungszeitraum oder permanent stattfindet und/oder durch eine Bedienperson willkürlich ein neuer Startzeitpunkt eines Aufzeichnungszeitraums von Übertragungssignalen festlegbar ist.

7. Verfahren nach einem der vorhergehenden Ansprüche, **dadurch gekennzeichnet, dass** eine zeitliche Entwicklung wenigstens einer Schadenstelle (40) aus einem oder mehreren Aufzeichnungszeiträumen anhand permanenter Aufzeichnung des Übertragungssignals gewonnen wird oder separat aufgezeichnet wird.

8. Signalübermittlungssystem (10) zur Durchführung eines Verfahrens zur Fehlerermittlung an elektrischen Signaltransportmitteln (20), insbesondere eines Verfahrens nach einem der vorhergehenden Ansprüche, mit wenigstens einem Signaltransportmittel (20), wobei an wenigstens einem Ende einer Übertragungsstrecke (25) des Signaltransportmittels (20) zumindest eine Signalverarbeitungseinrichtung (30) mit einer Schaltkreisanordnung (32) vorgesehen ist, welche im Nutzbetrieb über die Übertragungsstrecke (25) übertragene Übertragungssignale aufzeichnet und in einen Nutzsignalanteil und zumindest einen weiteren Anteil, insbesondere einen Reflektionsanteil, unterscheidet.

9. Signalübermittlungssystem (10) nach Anspruch 8, **dadurch gekennzeichnet, dass** in der zumindest einen Schaltkreisanordnung (32) Signalverarbeitungsmethoden zur Durchführung einer passiven Diagnostik des wenigstens einen Signaltransportmittels (20) implementiert sind.

10. Signalübermittlungssystem (10) nach Anspruch 8 oder 9, **dadurch gekennzeichnet, dass** an jedem Ende der Übertragungsstrecke (25) des Signaltransportmittels (20) wenigstens eine Schaltkreisanordnung (32) zur Durchführung einer passiven Diagnostik vorgesehen ist.

11. Signalübermittlungssystem (10) nach einem der Ansprüche 8 bis 10, **dadurch gekennzeichnet, dass** die zumindest eine Schaltkreisanordnung (32) als PHY-Schaltkreis ausgebildet ist.

12. Signalübermittlungssystem (10) nach einem der Ansprüche 8 bis 11, **dadurch gekennzeichnet, dass** die zumindest eine Schaltkreisanordnung (32) einen Bestandteil einer Schnittstelle eines Netzwerkes, insbesondere einer Schnittstellenkarte bildet.

13. Signalübermittlungssystem (10) nach einem der Ansprüche 8 bis 12, **dadurch gekennzeichnet, dass** wenigstens eine Schnittstelle zu einem Datenübertragungssystem und/oder wenigstens eine Speichereinrichtung vorgesehen ist.

14. Signalübermittlungssystem (10) nach einem der vorhergehenden Ansprüche, **dadurch gekennzeichnet, dass** das Signaltransportmittel (20) durch zumindest ein Paar von sich zwischen den Enden der Übertragungsstrecke (25) erstreckenden Kabeln, insbesondere von Kupferkabeln, gebildet ist, die zur Übertragung von Nutzsignalen mit einer Bandbreite von wenigstens 100 Mbit/s, insbesondere im Vollduplexbetrieb (60), ausgebildet sind.
